# EUROPÄISCHE PATENTSCHRIFT

(11) **EP 1 053 423 B1**
(45) Veröffentlichungstag und Bekanntmachung des Hinweises auf die Patenterteilung: **25.08.2004**
(21) Anmeldenummer: 99963203.7
(22) Anmeldetag: 05.11.1999
(51) Int. Cl.: F16K 31/00

(54) **PIEZOELEKTRISCHER AKTOR**
PIEZOELECTRIC ACTUATOR
ACTIONNEUR PIEZOELECTRIQUE

(30) Priorität: 05.12.1998 DE 19856202
(43) Veröffentlichungstag der Anmeldung: 22.11.2000
(73) Patentinhaber: ROBERT BOSCH GMBH, 70442 Stuttgart (DE)
(72) Erfinder: HEINZ, Rudolf, D-71272 Renningen (DE)
(86) Internationale Anmeldenummer: PCT/DE1999/003530
(87) Internationale Veröffentlichungsnummer: WO 2000/034699

(56) Entgegenhaltungen:
- EP-A- 0 576 707
- DE-A- 19 650 900
- DE-A- 19 712 921
- GB-A- 2 094 940
- US-A- 3 555 297

## Beschreibung

### Stand der Technik

Die Erfindung geht aus von einem piezoelektrischen Aktor, nach dem Oberbegriff von Anspruch 1.

Ein derartiger piezoelektrischer Aktor ist zum Beispiel bekannt aus DE 197 12 921 A1.

Wie allgemein bekannt, können piezoelektrische Aktoren zum Beispiel für Einspritzventile eines Kraftfahrzeugmotors sowie in Bremssystemen mit Antiblockiersystem und Antischlupfregelungen eingesetzt werden.

Derartige mit piezoelektrischen Aktoren ausgestattete Einspritzventile besitzen eine durch ein stößelartiges Verschlußorgan gesteuerte Einspritzdüse. Am Stößel ist eine düsenseitige Wirkfläche angeordnet, die vom Druck des der Düse zugeführten Kraftstoffs beaufschlagt wird, wobei die Druckkräfte den Stößel in Öffnungsrichtung des Verschlußorganes zu drängen suchen. Der Stößel ragt mit einem plungerartigen Ende, dessen Querschnitt größer ist als die vorgenannte Wirkfläche, in eine Steuerkammer hinein. Der dort wirksame Druck sucht den Stößel in Schließrichtung des Verschlußorganes zu bewegen. Die Steuerkammer ist über eine Eingangsdrossel mit der unter hohem Druck stehenden Kraftstoffzufuhr und über ein in der Regel gedrosseltes bzw. mit einer Ausgangsdrossel kombiniertes Auslaßventil mit einer nur geringen druckaufweisenden Kraftstoffrückführleitung verbunden. Bei geschlossenem Auslaßventil steht in der Steuerkammer ein hoher Druck an, durch den der Stößel gegen den Druck an seiner düsenseitigen Wirkfläche in Schließrichtung des Verschlußorganes bewegt bzw. in Verschlußstellung gehalten wird. Beim Öffnen des Auslaßventils fällt der Druck in der Steuerkammer ab, wobei das Maß des Druckabfalles durch die Bemessung der Eingangsdrossel und des Drosselwiderstandes des geöffneten Ausgangsventiles bzw. der damit kombinierten Ausgangsdrossel bestimmt wird. Im Ergebnis vermindert sich der Druck in der Steuerkammer bei geöffnetem Auslaßventil derart, daß der Stößel aufgrund der an seiner düsenseitigen Wirkfläche wirksamen Druckkräfte in Öffnungsrichtung des Verschlußorgans bewegt bzw. in Offenstellung gehalten wird.

Im Vergleich mit elektromagnetisch betätigten Einspritzventilen können piezoelektrische Aktoren schneller schalten. Allerdings muß beim Aufbau eines piezoelektrischen Aktors beachtet werden, daß durch innere Verluste im piezoelektrischen Körper des Aktors Verlustwärme entsteht, die abgeführt werden muß, damit sich der Aktor nicht überhitzt. Da die Keramikmaterialien der Piezokeramik eine schlechte Wärmeleitfähigkeit haben, ist die Wärmeableitung innerhalb des im wesentlichen aus Keramikmaterial bestehenden Aktorkörpers ungünstig.

Eine Kühlung des Aktors mit einem flüssigen Kühlmittel, wie zum Beispiel Kraftstoff, Wasser, Motoröl und dergleichen, ist ebenfalls ungünstig, zum einen wegen der Gefahr eines Kurzschlusses durch den auch im Kraftstoff und im Motoröl enthaltenen Wasseranteil und zum anderen wegen der Verteuerung des Aktormoduls aufgrund aufwendiger Abdichtungen, die eine Leckage des verwendeten Kühlmittels insbesondere bei Erwärmung des Aktors ausschließen müssen.

Aus der DE 197 12 921 A1 und der GB 2 094 940 A sind luftgekühlte Piezoaktoren bekannt, bei denen der Aktorkörper direkt von der Kühlluft umströmt wird. Wegen der in der Kühlluft enthaltenen Feuchtigkeit und Verunreinigungen ist es notwendig, den Aktorkörper durch eine Schutzschicht oder einen Schutzmmantel davor zu schützen, was den Wärmeübergang und damit die Kühlwirkung beeinträchtigt. Außerdem findet bei diesen Piezaktoren ein Wärmetransport vom Zylinderkopf der Brennkraftmaschine zum Aktorkörper statt, was den Kühlluftbedarf erhöht.

### Aufgaben und Vorteile der Erfindung

Es ist deshalb Aufgabe der Erfindung, einen gattungsgemäßen piezoelektrischen Aktor so zu ermöglichen, daß eine Kühlung im Betrieb desselben mit Luft möglich ist, daß der piezoelektrische Aktor einfach montiert werden kann und keine besonderen Maßnahmen zum Schutz des Aktorkörpers vor der in der Kühlluft enthaltenen Feuchtigkeit notwendig sind.

Um diese Aufgaben zu lösen, ist ein erfindungsgemäßer piezoelektrischer Aktor dadurch gekennzeichnet, daß die Modulwand im Abschnitt des oberen Raums eine Lufteinströmöffnung und eine Luftausströmöffnung aufweist.

Ein erfindungsgemäß gestalteter piezoelektrischer Aktor kann zur Kühlung des Aktorkörpers Druckluft verwenden, die bei Nutzkraftwagen ohnehin zur Verfügung steht. Auch kleine, durch das Aktormodul strömende Luftmengen genügen schon für eine ausreichende Aktorkühlung, und der Bauaufwand ist gering, abgesehen vom Schlauchanschluß zur Kühlluftzufuhr. Die Funktionssicherheit des erfindungsgemäßen piezoelektrischen Aktors ist groß, da die in der Kühlluft enthaltene Feuchtigkeit nicht in direkten Kontakt mit dem Aktorkörper gelangt.

Durch die erfindungsgemäße Anordnung der Lufteinströmöffnung und der.Luftausströmöffnung wird der Wärmetransport vom Zylinderkopf der Brennkraftmaschine zum Aktorkörper unterbunden, was den Kühlbedarf am Aktorkörper verringern hilft.

Bei dem erfindungsgemäßen Piezoaktor ist lediglich Sorge dafür zu tragen, daß der obere Raum feuchtigkeitsdicht gegenüber dem unteren Raum abgedichtet ist. Bei dieser Ausführungsart kommt auch die Motorwärme nicht an den Aktorkörper. Dazu ist die am Aktorkopf querliegende Trennwand an ihrer Peripherie gegenüber der Aktorwand durch einen O-Ring abgedichtet. Zusätzlich kann der Aktorkörper und dessen Anschlußleitungen durch einen Elastomermantel oder Schrumpfschlauch ummantelt sein. Weiterhin kann oberhalb der Trennwand ein zusätzlicher Elastomerdichtring zur Abdichtung vorgesehen sein, welcher an seiner Peripherie durch radiale Noppen oder eine ringförmige Sicke an der Modulwand fixiert ist. Im inneren Bereich ist durch eine gut wärmeleitfähige Klebstoffschicht eine Abdichtung des oberen Raums gegenüber dem unteren Raum erreichbar.

Bei einer weiteren Variante kann zusätzlich ein Kühlblech gut wärmeleitend mit der Trennwand verbunden sein und für eine zusätzliche Kühlung sorgen, da es sich in dem von der Kühlluft durchströmten oberen Raum befindet.

Statt einer elastischen Dichtung aus Elastomermaterial kann auch eine Stahlmembran verwendet werden, die gleichzeitig eine gute Wärmeleitung hat und zu einer zusätzlichen Wärmeabfuhr vom unteren Raum des Aktormoduls in den von der Kühlluft durchströmten oberen Raums sorgt. Eine solche Stahlmembran kann durch Verschraubung mittels eines Schraubrings dicht und wärmeleitend mit.der Modulwand verbunden werden.

Besonders vorteilhaft läßt sich die Erfindung in Nutzkraftwagen zur Dieselkraftstoffeinspritzung in einem Common-Rail-Injektorsystem verwenden. Wie erwähnt, steht bei Nutzkraftwagen Druckluft zur Verfügung, von der eine kleine Luftmenge zur Kühlung des piezoelektrischen Aktors verwendet werden kann.

Nachstehend werden weitere vorteilhafte Merkmale eines erfindungsgemäß gestalteten piezoelektrischen Aktors anhand der verschiedene Ausführungsbeispiele beschreibenden Beschreibung noch deutlicher, wenn diese bezugnehmend auf die Zeichnung gelesen wird.

### Zeichnungen

Figur 1 zeigt als schematischen Längsschnitt eine erste erfindungsgemäße Ausführungsform eines piezoelektrischen Aktors; und die
Figuren 2A, 2B, 2C und 2D zeigen Ausschnitte bevorzugter Weiterbildungen der in Figur 1 dargestellten erfindungsgemäßen Ausführungsform.

### Ausführungsbeispiele

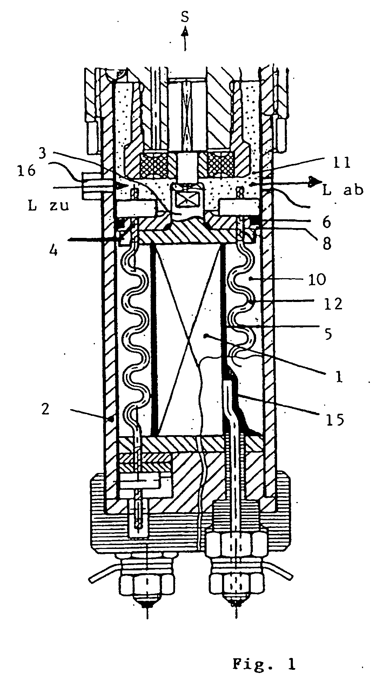

Bei dem in Figur 1 als Teilschnitt in Längsrichtung dargestellten ersten Ausführungsbeispiel eines erfindungsgemäßen piezoelektrischen Aktors ist ein Aktorkörper 1, der die Form eines vielschichtigen Laminats aus aufeinandergeschichteten Lagen piezoelektrischen Materials und dazwischenliegenden metallischen bzw. elektrisch leitenden als Elektroden dienenden Schichten haben kann, mit seinen Stirnseiten links und rechts durch zwei Federbänder 12 zwischen einem unteren, nicht näher bezeichneten ruhenden Aktorfuß und einer oberen, am Aktorkopf 3 liegenden, als Trennwand 8 ausgeführten axial beweglichen Platte, elastisch vorgespannt. Das Aktormodul ist von einer metallischen Aktorwand 2 eingeschlossen.

Wenn der Aktorkörper 1 mit einer pulsierenden elektrischen Spannung an seinen Elektroden beaufschlagt wird, führt er analog pulsierende Hübe unter Änderung des Abstandes zwischen seinen zwischen der oberen beweglichen Platte und dem unteren Aktorfuß durch die Federbänder 12 eingespannten Stirnseiten aus. Diese Hübe werden am Aktorkopf 3 über einen Kolben auf die (nicht dargestellte) Nadel eines Ventils übertragen (siehe Wirkungspfeil S). Zu bemerken ist außerdem, daß die Elektrodenzuleitungen von denen in Figur 1 nur eine sichtbar ist, nach unten zu nicht näher bezeichneten Anschlußklemmen geführt sind. Weiterhin unterteilt die axial bewegliche Trennwand 8 den den Aktorkörper 1 umgebenden Zwischenraum in einen unteren Raum 10, der den Aktorkörper 1 unmittelbar umgibt und einen über dem Aktorkopf 3 liegenden oberen Raum 11.

Bei der in Figur 1 gezeigten Ausführungsform ist der untere Raum 10 gegenüber dem oberen Raum 11 feuchtigkeitsdicht abgedichtet und nur der obere Raum 11 ist von Kühlluft durchströmt. Dazu ist in der Modulwand 2 eine Lufteinströmöffnung 16 und gegenüberliegend eine Luftausströmöffnung 17 angebracht, durch die Kühlluft Lzu einströmt und nach ihrer Kühlwirkung als ausströmende Luft Lab ausströmt. Der Luftstrom sorgt an dieser Stelle auch dafür, daß die Wärme vom Motorbereich durch Wärmeableitung nicht an den Aktorkörper 1 gelangt.

Zur Abdichtung des unteren Raums gegenüber dem oberen Raum 11 ist die Trennwand 8 im Bereich des Aktorkopfes 3 durch einen O-Ring 6 abgedichtet, der an der Innenseite der Modulwand 2 anliegt. Diese Abdichtung mit dem O-Ring 6 ermöglicht die axiale Beweglichkeit der Trennwand 8 und ist ausreichend, um Wasseransammlung im eigentlichen Aktorbereich, d. h. im Bereich des Aktorkörpers 1 zu vermeiden.

Fugen 4 an Stellen, an denen die Spannfedern 12 die bewegliche Trennwand 8 durchstoßen, sind mit Klebstoff dicht verklebt.

Vorteilhaft ist es auch hier, wenn der Aktorkörper 1 und die Elektrodenanschlüsse jeweils von einem Elastomermantel 5, 15 ummantelt sind. Statt des Elastomermantels kann auch ein elastischer Lack zur Abdichtung und Isolation dienen oder ein Schrumpfschlauch.

Figur 2A zeigt in vergrößerter Darstellung einen um den Aktorkopf 3 liegenden Abschnitt einer gegenüber der Ausführungsform in Figur 1 verbesserten Ausführung. Zur Verbesserung der Abdichtung an der querliegenden Trennwand mit dem O-Ring 6 ist gemäß den Figuren 2A-2C ein Elastomerdichtring 18 eingebaut, der in seiner axialen Position durch radiale Noppen 19 in der Modulwand fixiert ist. Der Elastomerdichtring kann gemäß Figur 2A ein Verbundkörper aus einem radial innenliegenden Metallring 18a einem radial außenliegenden Metallring 18b und einem dazwischen eingeschlossenen Elastomerring 18c sein. Innen wird im Bereich des Aktorkopfs durch eine gut wärmeleitfähige Klebstoffschicht 20 abgedichtet.

Zur besseren Wärmeabfuhr ist zusätzlich noch ein Kühlblech 21 gut wärmeleitend mit dem inneren Metallring 18a verbunden. Das Kühlblech 21 ragt in den von der Kühlluft durchströmten oberen Raum 11.

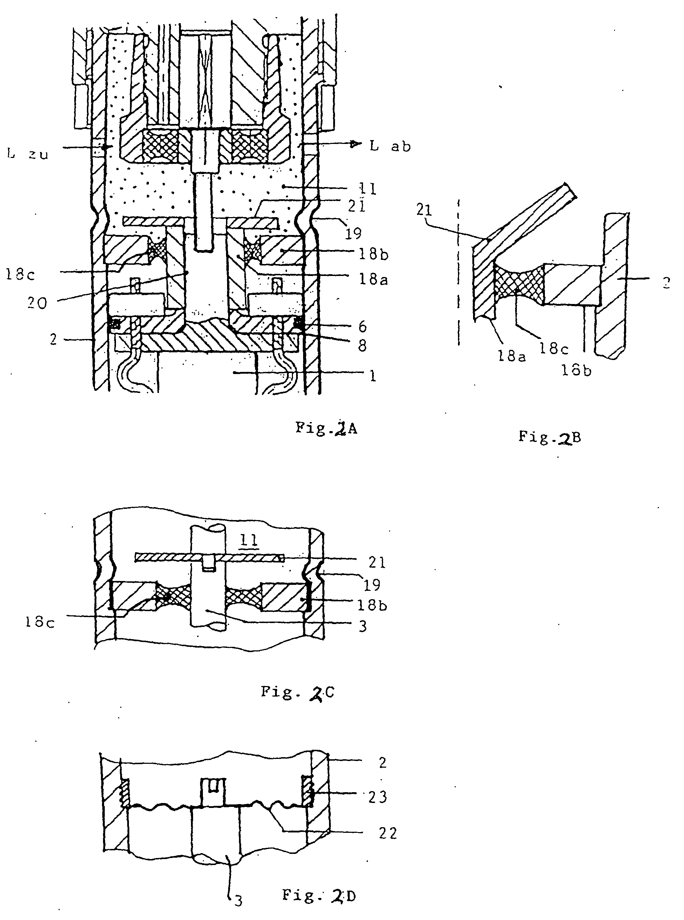

Figur 2B zeigt eine Variante, bei der das Kühlblech 21 einstückig mit dem aus den drei Abschnitten 18a, 18c, 18b bestehenden Elastomerdichtring 18 ist.

In Figur 2C ist eine weitere Variante dargestellt, bei der die Abdichtung mit einem Elastomerring 18, der wie in Figur 2A gestaltet ist, ohne festen Innenring, wie bei einem wellendichtring, erfolgt. Der Innenring 18a wird ersetzt durch den Aktorkopf 3.

Figur 2D schließlich zeigt, daß die Abdichtung des unteren Raums 10 gegen den oberen Raum 11 statt mit einer Elastomerdichtung durch eine Stahlmembran 22 erfolgt. Eine solche Metallmembran 22 besitzt eine hervorragende Dichtwirkung und gleichzeitig eine gute Wärmeleitfähigkeit. Die Membran 22 ist gemäß Figur 2D mit einem Schraubring 23 an der Modulwand 2 festgelegt und ermöglicht dennoch die axiale Beweglichkeit des Aktorkopfs. Die Membran wird innen an den Aktorkopf 3 angeschweißt.

Mit den erfindungsgemäßen Kühlmitteln, d.h. der den oberen Raum 11 durchströmenden Kühlluft und gegebenenfalls den zusätzlichen Maßnahmen, wie dem Kühlblech und der gut wärmeleitenden Verbindung zwischen Kühlblech und der Trennwand 8 im Bereich des Aktorkopfs 3 bzw. mit der dichten Stahlmembran 22 gemäß Figur 2D eignet sich ein erfindungsgemäßer piezoelektrischer Aktor sehr gut zum Schalten von Injektoren, wie sie zum Einspritzen von Dieselkraftstoff bei Common-Rail-Injektorsystemen verwendet werden. Insbesondere bei Nutzkraftwagen kann ein geringer Anteil der ohnehin vorhanden Druckluft zur Kühlung des piezoelektrischen Aktors verwendet werden. Auch kleine Luftmengen genügen schon für eine ausreichende Aktorkühlung, und der Bauaufwand ist gering, abgesehen vom Schlauchanschluß für die Zu- und Abfuhr der Kühlluft. Die Funktionssicherheit ist groß, da kein flüssiges Kühlmittel,
wie zum Beispiel Kraftstoff, Motoröl oder Wasser verwendet wird. Außerdem wird der Aktor sicher vor Luftfeuchtigkeit geschützt und die Motorwärme kommt im Betrieb nicht an den Aktor.

## Patentansprüche

1. Piezoelektrischer Aktor, insbesondere zur Betätigung von Steuerventilen oder Einspritzventilen an Verbrennungsmotoren in Kraftfahrzeugen, mit einem piezoelektrischen Aktorkörper (1) insbesondere in Form eines vielschichtigen Laminats aus aufeinandergeschichteten Lagen piezoelektrischen Materials und dazwischenliegenden metallischen bzw. elektrisch leitenden, als Elektroden dienenden Schichten, wobei der Aktorkörper (1) unter Einhaltung eines durch eine am Aktorkopf (3) querliegende axial bewegliche Trennwand (8) in einen oberen (11) und unteren Raum (10) unterteilten Zwischenraums (10, 11) von einer Modulwand (2) umgeben ist, und wobei der Aktorkörper (1) durch einen Kühlluftstrom (1) gekühlt wird, **dadurch gekennzeichnet, daß** die Modulwand (2) im Abschnitt des oberen Raums (11) eine Lufteinströmöffnung (16) und eine Luftauströmöffnung (17) aufweist.

2. Piezoelektrischer Aktor nach Anspruch 1, **dadurch gekennzeichnet, daß** der untere Raum (10) gegenüber dem oberen Raum (11) feuchtigkeitsdicht abgedichtet ist.

3. Piezoelektrischer Aktor nach einem der Ansprüche 1 oder 2, **dadurch gekennzeichnet, daß** die querliegende Trennwand (8) an ihrer Peripherie gegenüber der Aktorwand (2) durch einen O-Ring (6) abgedichtet ist.

4. Piezoelektrischer Aktor nach einem der vorhergehenden Ansprüche, **dadurch gekennzeichnet, daß** der Aktorkörper (1) einschließlich seiner Stromanschlüsse im unteren Raum (10) durch einen Elastomermantel (5, 15) bzw. Schrumpfschlauch oder eine Lackschicht zum Schutz gegen Feuchtigkeit ummantelt ist.

5. Piezoelektrischer Aktor nach einem der vorhergehenden Ansprüche, **dadurch gekennzeichnet, daß** zusätzlich ein Elastomerdichtring (18) zur Abdichtung des oberen Raums (11) gegenüber dem unteren Raum (10) oberhalb der querliegenden Trennwand (8) vorgesehen ist.

6. Piezoelektrischer Aktor nach Anspruch 5, **dadurch gekennzeichnet, daß** der Elastomerdichtring (18) durch in der Modulwand (2) angebrachte radiale Noppen (19) oder eine ringförmige Sicke axial fixiert ist.

7. Piezoelektrischer Aktor nach Anspruch 5 oder 6, **dadurch gekennzeichnet, daß** der obere Raum (11) gegenüber dem unteren Raum im Inneren durch eine gut wärmeleitfähige Klebstoffschicht (20) abgedichtet ist.

8. Piezoelektrischer Aktor nach einen der vorangehenden Ansprüche, **dadurch gekennzeichnet, daß** die querliegende Trennwand (8) aus Metall besteht und mit einem in den oberen Raum (11) ragenden Kühlblech (21) gut wärmeleitend verbunden ist.

9. Piezeoelektrischer Aktor nach Anspruch 8, **dadurch gekennzeichnet, daß** das Kühlblech und der Elastomerdichtring eine Einheit bilden.

10. Piezoelektrischer Aktor nach einem der vorhergehenden Ansprüche, **dadurch gekennzeichnet, daß** zusätzlich oberhalb der querliegenden Trennwand (8) eine Stahlmembran (22) vorgesehen ist, die elastisch den oberen Raum (11) gegenüber dem unteren Raum (10) abdichtet.

11. Piezeoelektrischer Aktor nach Anspruch 10, **dadurch gekennzeichnet, daß** die Stahlmembran (22) durch einen Schraubring (23) form- und kraftschlüssig und gut wärmeleitend am Inneren der Modulwand (2) festgelegt ist.

12. Piezoelektrischer Aktor nach Anspruch 10, **dadurch gekennzeichnet, daß** die Stahlmembran (22) innen an den Aktorkopf (3) angeschweißt ist.

## Claims

1. Piezoelectric actuator, in particular for actuating control valves or injection valves in internal combustion engines in motor vehicles, having a piezoelectric actuator body (1), in particular in the form of a multilayer laminate of layered plies of piezoelectric material and interposed metallic or electrically conducting layers serving as electrodes, the actuator body (1) being surrounded by a module wall (2), while maintaining an intermediate space (10, 11), the intermediate space (10, 11) being subdivided into an upper space (11) and lower space (10) by an axially movable partition (8) located transversely on the actuator head (3), and the actuator body (1) being cooled by a cooling air stream (1), **characterized in that** the module wall (2) has in the portion comprising the upper space (11) an air inflow opening (16) and an air outflow opening (17).

2. Piezoelectric actuator according to Claim 1, **characterized in that** the lower space (10) is sealed off from the upper space (11) against moisture.

3. Piezoelectric actuator according to either of Claims 1 and 2, **characterized in that** the transverse partition (8) is sealed off from the actuator wall (2) at its periphery by an O-ring (6).

4. Piezoelectric actuator according to one of the preceding claims, **characterized in that** the actuator body (1), including its power terminals in the lower space (10), is sheathed by an elastomer jacket (5, 15) or shrink-fit tube or a layer of paint to protect against moisture.

5. Piezoelectric actuator according to one of the preceding claims, **characterized in that** an elastomer sealing ring (18) is additionally provided above the transverse partition (8) to seal off the upper space (11) from the lower space (10).

6. Piezoelectric actuator according to Claim 5, **characterized in that** the elastomer sealing ring (18) is axially fixed by radial bumps (19) or an annular bead provided in the module wall (2).

7. Piezoelectric actuator according to Claim 5 or 6, **characterized in that** the upper space (11) is sealed off from the lower space in the interior by a layer of adhesive (20) with good thermal conductivity.

8. Piezoelectric actuator according to one of the preceding claims, **characterized in that** the transverse partition (8) consists of metal and is connected with good thermal conduction to a cooling plate (21) protruding into the upper space (11).

9. Piezoelectric actuator according to Claim 8, **characterized in that** the cooling plate and the elastomer sealing ring form a unit.

10. Piezoelectric actuator according to one of the preceding claims, **characterized in that** a steel diaphragm (22), which elastically seals off the upper space (11) from the lower space (10), is additionally provided above the transverse partition (8).

11. Piezoelectric actuator according to Claim 10, **characterized in that** the steel diaphragm (22) is fixed on the inside of the module wall (2) with a positive and non-positive connection and good heat conduction by a screw ring (23).

12. Piezoelectric actuator according to Claim 10, **characterized in that** the steel diaphragm (22) is welded onto the inside of the actuator head (3).

## Revendications

1. Actionneur piézo-électrique notamment pour actionner des soupapes de commande ou des soupapes d'injection ou injecteurs de moteurs à combustion interne de véhicules automobiles comprenant un corps d'actionneur (1) piézo-électrique, notamment sous la forme d'un stratifié à plusieurs couches, formé de couches de matière piézo-électrique, superposées avec interposition de couches métalliques ou électro-conductrices servant d'électrodes,
le corps (1) de l'actionneur étant entouré par une paroi de module (2) en respectant un volume intermédiaire (10, 11) subdivisé par une cloison (8) mobile axialement, transversale au niveau de la tête d'actionneur (3) en un volume supérieur (11) et un volume inférieur (10), et
le corps d'actionneur (1) est refroidi par une veine d'air de refroidissement (1),
**caractérisé en ce que**
dans le segment du volume supérieur (11), la paroi de module (2) comporte un orifice d'entrée d'air (16) et un orifice de sortie d'air (17).

2. Actionneur piézo-électrique selon la revendication 1,
**caractérisé en ce que**
le volume inférieur (10) est rendu étanche à l'humidité vis-à-vis du volume supérieur (11).

3. Actionneur piézo-électrique selon l'une des revendications 1 ou 2,
**caractérisé en ce que**
la cloison transversale (8) est rendue étanche par un joint torique (6) au niveau de sa périphérie par rapport à la paroi de l'actionneur (2).

4. Actionneur piézo-électrique selon l'une des revendications précédentes,
**caractérisé en ce que**
le corps de l'actionneur (1), y compris ses branchements électriques, est entouré dans le volume intérieur (10) par une enveloppe d'élastomère (5, 15) ou un tuyau rétractable ou une couche de vernis pour être protégé contre l'humidité.

5. Actionneur piézo-électrique selon l'une des revendications précédentes,
**caractérisé en ce qu'**
pour assurer l'étanchéité du volume supérieur (11) par rapport au volume inférieur (10) au-dessus de la cloison transversale (8) on a en outre un anneau d'étanchéité (18) en élastomère.

6. Actionneur piézo-électrique selon la revendication 5,
**caractérisé en ce que**
l'anneau d'étanchéité en élastomère (18) est bloqué axialement par des bossages radiaux (19) réalisés dans la paroi de module (2) ou par une nervure annulaire.

7. Actionneur piézo-électrique selon la revendication 5 ou 6,
**caractérisé en ce qu'**
à l'intérieur, le volume supérieur (11) est rendu étanche par rapport au volume inférieur (10), par une couche adhésive (20) bonne conductrice de chaleur.

8. Actionneur piézo-électrique selon l'une des revendications précédentes,
**caractérisé en ce que**
la cloison transversale (8) est en métal et est reliée par une liaison à bonne conduction thermique avec une tôle de refroidissement (21) pénétrant dans le volume supérieur (11).

9. Actionneur piézo-électrique selon la revendication 8,
**caractérisé en ce que**
la tôle de refroidissement (21) et l'anneau d'étanchéité en élastomère (18) forment un ensemble.

10. Actionneur piézo-électrique selon l'une des revendications précédentes,
**caractérisé en ce qu'**
une membrane en acier (22) qui sépare élastiquement de manière étanche, le volume supérieur (11) par rapport au volume inférieur (10) se trouve en outre au-dessus de la cloison transversale (8).

11. Actionneur piézo-électrique selon la revendication 10,
**caractérisé en ce que**
la membrane en acier (22) est fixée par un anneau vissé (23), par une liaison de forme et de force et avec une bonne liaison de conduction thermique à l'intérieur de la paroi de module (2).

12. Actionneur piézo-électrique selon la revendication 10,
**caractérisé en ce que**
la membrane d'acier (22) est soudée à l'intérieur à la tête d'actionneur (3).
